Europäisches Patentamt

European Patent Office

Office européen des brevets

(11) Veröffentlichungsnummer: **0 241 692**
**A2**

# (12) EUROPÄISCHE PATENTANMELDUNG

(21) Anmeldenummer: **87103089.6**

(22) Anmeldetag: **04.03.87**

(51) Int. Cl.⁴: **H01L 25/04 , H01L 31/02**

(30) Priorität: **25.03.86 DE 3610083**

(43) Veröffentlichungstag der Anmeldung:
**21.10.87 Patentblatt 87/43**

(84) Benannte Vertragsstaaten:
**DE FR GB**

(71) Anmelder: **Siemens Aktiengesellschaft Berlin und München**
**Wittelsbacherplatz 2**
**D-8000 München 2(DE)**

(72) Erfinder: **Winstel, Günter, Dr.rer.nat.**
**Osserweg 3**
**D-8012 Ottobrunn(DE)**
Erfinder: **Plättner, Rolf, Dr.phil.nat.**
**Pommernstrasse 3**
**D-8012 Ottobrunn(DE)**

(54) **Anordnung zur Vermeidung ungewollter Degradation im Leerlaufbetrieb von insbesondere aus amorphem Silizium bestehenden Solarzellen-Modulen.**

(57) Zur Vermeidung ungewollter Degradation im Leerlaufbetrieb von insbesondere aus amorphem Silizium bestehenden Solarzellen-Modulen (1) wird im Modul (1) ein innerer Lastwiderstand $R_L$ integriert, der beim Betrieb des Modul abgeschaltet wird. Das Abschalten erfolgt entweder auf mechanischem Wege durch einen im Stecker (5) zum Verbraucher eingebauten Schalter (7) oder auf elektronischem Wege automatisch über eine einfache, kostengünstige Schaltung. Die Anordnung wird verwendet beim Betrieb von Solarzellen-Modulen für Anlagen mit nicht kontinuierlichem Verbrauch, wie zum Beispiel Geräten in Wohnwagen, Berghütten usw.

FIG 1

EP 0 241 692 A2

## Anordnung zur Vermeidung ungewollter Degradation im Leerlaufbetrieb von insbesondere aus amorphem Silizium bestehenden Solarzellen-Modulen.

Die Erfindung betrifft eine Anordnung zur Vermeidung ungewollter Degradation im Leerlaufbetrieb von insbesondere aus amorphem Silizium bestehenden Solarzellen, die in Modulen zusammengeschaltet sind.

Solarzellen lassen sich insbesondere dort vorteilhaft einsetzen, wo geringe Wartung für Anlagen oder Geräte möglich ist oder andere elektrische Energiequellen nicht vorhanden sind. Letzteres gilt besonders für den Einsatz von Kleingeräten für Wohnwagen, Segelboote, Berghütten oder dergleichen.

Amorphe Siliziumsolarzellen gewinnen in letzter Zeit immer mehr an Bedeutung. Sie haben gegenüber kristalliner Siliziumsolarzellen den Vorteil der billigeren Herstellung wegen ihrer Dünnschichtbauweise. Die Stabilität von Solarzellen aus amorphem Silizium wirft aber Probleme auf, deren Beseitigung Gegenstand vieler Untersuchungen geworden ist. So ist zum Beispiel aus einem Bericht von M. Moeller et. al. aus dem Tagungsband des Materials Research Society Symposiums 1985, Vol. 49, Seiten 325 bis 330 bekannt, das Stabilitätsverhalten von amorphem Siliziumsolarzellen dadurch zu verbessern, daß bei den pin-Solarzellen mit einer aus dotiertem Zinnoxid bestehenden, transparenten Grundelektrode in die i-Schicht ein in Richtung i-n-Übergang abnehmendes Bordotierungsprofil eingebaut wird, wenn der Lichteinfall von der n-Seite her erfolgt, oder daß bei Bestrahlung von der p-Seite her die i-Schicht ein in Richtung i-n-Übergang ansteigendes Phosphordotierungsprofil enthält.

Auch die hier diskutierten Maßnahmen führen zu Solarzellen bzw. Modulen, bei denen unter Last, das heißt bei angeschlossenem Verbraucher, eine erheblich geringere Alterung auftritt als im Leerlauf des Modul. Das ist besonders in den Modulen mit Wirkungsgraden größer 5% der Fall, die mit dem Zellentyp Glassubstrat/Zinnoxid als Grundelektrode/p-SiC-i-n als Dünnschicht/Metall als Rückelektrode hergestellt werden.

Die Degradation dieser Module kann bei geeigneter Herstellung nach einer Anfangsalterung von wenigen Prozent sehr gering sein, zum Beispiel kleiner 10% nach 10 Jahren Betrieb im Sonnenlicht, wenn sie dauernd unter Last betrieben werden. Der Betrieb unter Leerlaufbedingungen kann dagegen zur Verdoppelung der Degradation führen. Diese Leerlaufbedingungen stellen sich ein, wenn das Modul versehentlich nicht am Verbraucher angeschlossen ist, oder wenn der Verbraucher trotz Kabelabschluß absichtlich oder unabsichtlich, zum Beispiel bei Kabeldefekt, vom Modul getrennt wird. Als Effekt tritt in jedem Fall eine vorzeitige, unbemerkte Abnahme der Modul-Leistung, bedingt durch die Degradation, auf.

Aufgabe der Erfingung ist es daher, diesen Effekt der Degradation ohne größeren Aufwand zu verhindern.

Dies geschieht bei einer Anordnung der eingangs genannten Art erfindungsgemäß dadurch, daß im Modul ein innerer Lastwiderstand $R_L$ integriert ist, der beim Betrieb des Modul abgeschaltet wird. Dabei liegt es im Rahmen der Erfindung, daß entweder ein im Stecker zum Verbraucher eingebauter Schalter vorgesehen ist, der auf mechanischem Wege eingeschaltet wird, wenn der Modul vom Verbraucher getrennt ist, oder, daß im Modul ein elektronischer Schalter vorgesehen ist, der automatisch auf den Betriebszustand "Leerlauf" oder "Last" reagiert.

Nachfolgend wird die Erfindung anhand der Figuren 1 bis 3 noch näher erläutert. Dabei zeigt die

Figur 1 schematisch die mechanische Methode und die

Figuren 2 und 3 die Arbeitsweise eines Moduls anhand einer Kennlinie (Figur 2).

Für gleiche Teile sind gleiche Bezugszeichen verwendet.

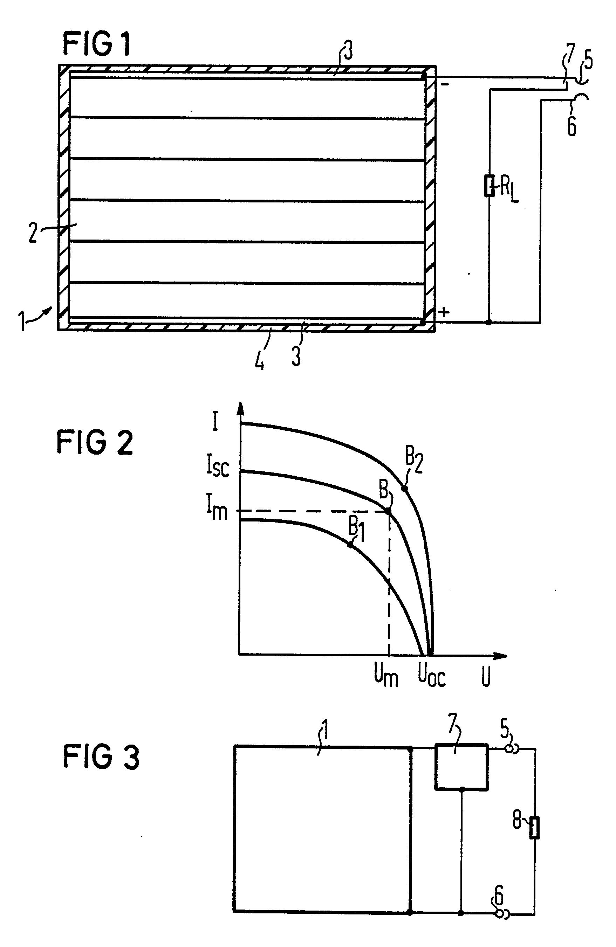

Figur 1 zeigt einen Modul 1, bestehend aus einer Mehrzahl von Solarzellen 2, die elektrisch leitend untereinander verbunden, mit zwei Kontaktleisten 3 versehen sind. Am Rahmen 4 des Modul 1 sind Kontakte 5 und 6 angebracht, durch die die elektrischen Strom erzeugenden Solarzellen 2 mit dem Verbraucher verbunden sind. Parallel zu einem dieser, als Stecker ausgebildeten Kontakte 5 wird nun ein Schalter 7 mit einem Lastwiderstand $R_L$ eingebaut, der geöffnet wird, wenn der Modul vom Verbraucher getrennt ist, das heißt im Leerlauf betrieben wird, und geschlossen wird, wenn der Verbraucher angeschlossen ist, das heißt, wenn der Modul im Betrieb ist.

Aus dem in Figur 2 gezeigten Kennlinienfeld ist ersichtlich, daß für den Betriebszustand "Leerlauf" $U_{oc}$ bei Beleuchtung ($B_1$, $B$, $B_2$) eine relativ steile Abhängigkeit des Stromes I von der Spannung U bzw. vom Verbraucher (8 in Figur 3) kennzeichnend ist. Diese steile Abhängigkeit kann für das Einschalten des inneren Lastwiderstandes $R_L$ (innerhalb des elektronischen Lastschalters 7 in Figur 3) genutzt werden, da sie sich vom Verhalten am Arbeitspunkt B der Kennlinie unterscheidet. Die Kurven $B_1$, B, $B_2$ gelten für unterschiedliche Beleuchtungsstärken. Mit $I_{sc}$ ist der Kurzschlußstrom bezeichnet.

Eine weitere Möglichkeit bietet sich dadurch an, daß der Stromfluß über den Verbraucher selbst als Signal genutzt wird.

In einer anderen Schaltungsform können Spannung und Strom, in geeigneter Form abgegriffen, so genutzt werden, daß nur dann, wenn das Signal $I_m/U_m$ (siehe Figur 2) einen bestimmten Wert überschreitet, der innere Lastwiderstand $R_L$ abgeschaltet wird. In allen Fällen kann eine einfache, kostengünstige Schaltung benutzt werden, die die Kosten des Modul nicht wesentlich beeinflußt und nur einen geringen Leistungsbedarf hat. .

## Ansprüche

1. Anordnung zur Vermeidung ungewollter Degradation im Leerlaufbetrieb von insbesondere aus amorphem Silizium bestehenden Solarzellen (2), die in Modulen (2) zusammengeschaltet sind, **dadurch gekennzeichnet,** daß im Modul (1) ein innerer Lastwiderstand $R_L$ integriert ist, der beim Betrieb des Modul (1) abgeschaltet wird.

2. Anordnung nach Anspruch 1, **dadurch gekennzeichnet,** daß ein im Stecker (5) zum Verbraucher (8) eingebauter Schalter (7) vorgesehen ist, der auf mechanischem Wege eingeschaltet wird, wenn der Modul (1) vom Verbraucher (8) getrennt ist.

3. Anordnung nach Anspruch 1, **dadurch gekennzeichnet,** daß im Modul (1) ein elektronischer Schalter vorgesehen ist, der automatisch auf den Betriebszustand "Leerlauf" oder "Last" reagiert.

4. Anordnung nach Anspruch 3, **dadurch gekennzeichnet,** daß der Stromfluß über den Verbraucher (8) selbst als Signal für den Schaltvorgang verwendet wird.

5. Anordnung nach einem der Ansprüche 3 oder 4, **dadurch gekennzeichnet,** daß als Signal für das Abschalten des Schalters im Modul ein bestimmter, das Strom-Spannungs-Verhältnis von $I_m/U_m$ benutzender Wert gewählt wird (Figur 2).

## FIG 1

## FIG 2

## FIG 3